# EUROPÄISCHE PATENTSCHRIFT

(11) **EP 2 740 139 B1**
(45) Veröffentlichungstag und Bekanntmachung des Hinweises auf die Patenterteilung: **29.07.2015**
(21) Anmeldenummer: 12753413.9
(22) Anmeldetag: 03.08.2012
(51) Int. Cl.: H01H 37/76, H01T 1/14, H05K 1/02

(54) **THERMISCHE ÜBERLASTSCHUTZVORRICHTUNG**
THERMAL OVERLOAD PROTECTION APPARATUS
DISPOSITIF DE PROTECTION CONTRE LES SURCHARGES THERMIQUES

(30) Priorität: 03.08.2011 DE 102011052390
(43) Veröffentlichungstag der Anmeldung: 11.06.2014
(73) Patentinhaber: Phoenix Contact GmbH & Co. KG, 32825 Blomberg (DE)
(72) Erfinder: DURTH, Rainer, 32805 Horn-Bad Meinberg (DE); MEYER, Thomas, 31868 Ottenstein (DE)
(74) Vertreter: Michalski Hüttermann & Partner Patentanwälte mbB
(86) Internationale Anmeldenummer: PCT/EP2012/065231
(87) Internationale Veröffentlichungsnummer: WO 2013/017682

(56) Entgegenhaltungen:
- DE-A1- 19 615 643
- FR-A1- 2 914 108

## Beschreibung

Die Erfindung betrifft eine thermische Überlastschutzvorrichtung zum Schutz eines elektrischen Bauelements, die ein Schaltelement zum Kurzschließen von Anschlüssen des Bauelements oder zum Auftrennen einer elektrisch leitenden Verbindung zwischen mindestens einem der Anschlüsse und einem Stromführungselement der Überlastschutzvorrichtung, eine Aktorvorrichtung zum Verlagern des Schaltelements in eine entsprechende Kurzschlussposition oder Trennposition und ein die Aktorvorrichtung thermosensitiv auslösendes Auslöseelement aufweist, das als Separierelement ausgebildet ist. Die Erfindung betrifft weiterhin ein Verfahren zur Herstellung eines Verbunds aus einem Schaltelement, einem Basiselement und einem Separierelement für eine entsprechende Überlastschutzvorrichtung.

Eine derartige Überlastschutzvorrichtung ist zum Beispiel aus der Offenlegungsschrift DE 10 2008 022 794 A1 bekannt. Diese beschreibt eine thermische Überlastschutzvorrichtung, die eine Kurzschlusseinrichtung mit federvorgespanntem Kurzschlussbügel zum Kurzschließen von Elektroden eines Überspannungsableiters und ein die Überlastschutzvorrichtung auslösendes Schmelzelement aufweist. Neben dieser Ausführung als Überlastschutzvorrichtung mit Schaltelement einer Kurzschlusseinrichtung ist auch eine Überlastschutzvorrichtung mit entsprechendem Schaltelement einer Abtrenneinrichtung denkbar.

Die Überbeanspruchung von elektronischen Bauelementen kann dazu führen, dass diese außerhalb eines Nennbetriebsbereiches arbeiten. Dabei führt ein zum Beispiel durch eine reduzierte Isolationsfestigkeit des Bauelements hervorgerufener Leistungsumsatz an einem geschädigten Bauelement zu eieiner erhöhten Erwärmung. Wird eine Erwärmung des Bauelements über eine Zulässigkeitsschwelle hinaus nicht verhindert, kann dies zum Beispiel zur Schädigung umgebender Materialien, Entstehung von Rauchgasen oder zu einer Brandgefahr führen.

Diese Gefahren ergeben sich auch bei einer Anordnung von auf einem Leiterbahnenträger angeordneten Bauelementen wie zum Beispiel oberflächenmontierbaren Bauelementen. Zum Aufbau einer derartigen Anordnung wird der Leiterbahnenträger (die Leiterplatte/Platine) mit entsprechenden Bauelementen zumeist von Automaten bestückt und verlötet. Aufgrund der dichten Bestückung ergibt sich oft nur ein sehr begrenzter Bauraum. Gleichzeitig entstehen lokal Temperaturen, die zumindest nahe an die Auslösetemperatur des Separierelements heranreichen.

Die DE 196 15 643 A1 zeigt eine Überspannungsschutzanordnung mit einem spannungebegrenzenden Element und einer Schaltanordnung, die eine thermische Überlastschutzvorrichtung zum Schutz des spannungsbegrenzenden Elements bildet. Die Schaltanordnung weist ein Schaltelement zum Kurzschließen von Anschlüssen des Bauelements oder zum Auftrennen einer elektrisch leitenden Verbindung zwischen mindestens einem der Anschlüsse und einem Stromführungselement der Schaltanordnung, eine Aktorvorrichtung zum Verlagern des Schaltelements in eine entsprechende Kurzschlussposition oder Trennposition, ein die Aktorvorrichtung thermosensitiv auslösendes und als Separierelement ausgebildetes Auslöseelement und ein Basiselement auf, mit dem das Separierelement verbunden ist, wobei das Basiselement an einer dem Separierelement abgewandten Seite des Basiselements mittels einer StandardLotverbindung verlötbar ist.

Der Erfindung liegt die Aufgabe zu Grunde, eine thermische Überlastschutzvorrichtung anzugeben, welche wenig Bauraum benötigt, sicher auf thermische Überlast anspricht und Kurzschließt beziehungsweise Trennt und sich trotz der dabei entstehenden Temperaturen einfach in einen Montageprozess einer Montage, insbesondere Oberflächenmontage, von Bauelementen auf einem Leiterbahnenträger integrieren lässt. Der Erfindung liegt weiterhin die Aufgabe zugrunde, ein entsprechendes Herstellungsverfahren anzugeben.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Die erfindungsgemäße Überlastschutzvorrichtung weist ein Basiselement auf, mit dem das Separierelement verbunden ist, wobei das Basiselement an seiner dem Separierelement abgewandten Seite mittels einer Standard-Lotverbindung verlötbar ist. Durch dieses Basiselement wird ein Zwischenelement zwischen dem thermosensitiven Separierelement und einer Verlötstelle der Überlastschutzvorrichtung gebildet, über die bei einem auslösenden Ereignis der Wärmetransport zum Separierelement erfolgt. Durch die Wärmekapazität des Basiselements wird ein Wärmepuffer geschaffen, das ein Verlöten der Überlastschutzvorrichtung durch einen kurzfristigen Lötprozess mit Standardlot auf der einen Seite des Basiselements ermöglicht, ohne dass das Separierelement Schaden nimmt.

An dieser Stelle sei darauf hingewiesen, dass der Begriff (auf)trennen sich auf die elektrisch leitenden Verbindung bezieht, während sich der Begriff separieren und Separierelement auf das mechanische separieren des mittels Standard-Lotverbindung verlötbaren Basiselements von einem restlichen Teil der Überlastschutzvorrichtung zu Auslösezwecken bezieht. Das Separieren kann gleichzeitig ein Auftrennen sein, muss es -insbesondere im Fall der Nutzung des Schaltelements zum Kurzschließen- jedoch nicht.

Das Bauelement ist bevorzugt ein mit seinen Anschlüssen auf einem Leiterbahnenträger mit Leiterbahnen montierbares beziehungsweise montiertes Bauelement. Das Stromführungselement der elektrisch leitenden Verbindung bei einem als Trenneinrichtung ausgebildeten elektrischen Schaltelement ist insbesondere eine der Leiterbahnen oder ein auf dem Leiterbahnenträger montiertes und mit einer der Leiterbahnen verschaltetes Stromführungselement. Die elektrisch leitende Verbindung ist eine Verbindung zur Beschaltung des Bauelements. Das Kurzschließen ist insbesondere ein Kurzschließen über mindestens eine der Leiterbahnen.

Mit Vorteil ist vorgesehen, dass das Separierelement als ein durch Schmelzen auslösendes Schmelzelement ausgebildet ist. Die Schmelztemperatur des Schmelzelements bestimmt die Auslösetemperatur, die somit über die Materialwahl einstellbar ist.

Gemäß einer bevorzugten Ausgestaltung der Erfindung ist vorgesehen, dass das durch Schmelzen auslösendes Schmelzelement einen niedrigeren Schmelzpunkt aufweist als das Lot der Standard-Lotverbindung. Das Schmelzelement weist als aktives Material zum Beispiel ein Funktionslot oder einen Schmelzkunststoff auf, die je einen deutlich niedrigeren Schmelzpunkt aufweisen als Standard-Lot (also dem Lot der Standard-Lotverbindung). Dabei ist unter einem deutlich niedrigeren Schmelzpunkt ein um 20 K oder mehr als 20 K (≥ 20 k beziehungsweise ≥ 20°C) niedriger Schmelzpunkt zu verstehen.

Verglichen mit einem Standard-Lot zeigt Schmelzkunststoff weiterhin einen weicheren Übergang seiner Konsistenz am Schmelzpunkt. Dies hat den Vorteil, dass ein Separierelement aus Schmelzkunststoff auch im Auslösefall an seinem ursprünglichen Ort verbleibt und durch das Auslösen lediglich seine Form derart verändert, dass die Kurzschlusseinrichtung das Bauelement kurzschließen kann.

Gemäß einer weiteren bevorzugten Ausgestaltung der Erfindung ist vorgesehen, dass das Basiselement über das unausgelöste Separierelement mit dem Schaltelement mechanisch verbunden ist. Insbesondere ist das elektrisch leitfähig ausgebildete Basiselement über das unausgelöste Separierelement auch elektrisch mit dem Schaltelement leitend verbunden. Ist das Schaltelement als eine Trenneinrichtung zum Auftrennen einer elektrisch leitenden Verbindung mindestens eines der Anschlüsse mit einem Stromführungselement ausgebildet, so ist das Schmelzelement bevorzugt eine Lotverbindung innerhalb der (aufzutrennenden) elektrisch leitenden Verbindung. Das mechanische Separieren von Basiselement und Schaltelement ist dann unmittelbar mit dem Auftrennen der elektrisch leitenden Verbindung gekoppelt.

Mit Vorteil ist vorgesehen, dass die Aktorvorrichtung zu ihrer Aktivierung von einem inaktiven Zustand, bei dem das Schaltelement von der Aktorvorrichtung auch durch Auslösen mittels Separierelement nicht verlagerbar ist, in einen auslösbaren Zustand umschaltbar ist, bei dem das Schaltelement von der mittels Separierelement auslösbaren Aktorvorrichtung verlagerbar ist. Die Begriffe "inaktiv" und "auslösbar" bedeutet also in diesem Zusammenhang, dass nur die durch das Umschalten aktivierte Aktorvorrichtung bei einem Auslösen eine zum Kurzschließen oder Trennen benötigte Kraft aufbringt und die nicht aktivierte, also inaktive Aktorvorrichtung selbst bei einem Auslösen mittels Separierelement keine oder eine zum Kurzschließen oder Trennen nicht ausreichende Kraft aufbringt. Eine derartige Überlastschutzvorrichtung kann ohne die Gefahr eines Auslösens auch mittels einer mit hohen Temperaturen verbundenen Montageart, wie zum Beispiel einem Löten, montiert werden. Dadurch wird ermöglicht, dass ein Aktivieren erst nach Erreichen einer unkritischen Temperatur oder zu einem anderen beliebig wählbaren Zeitpunkt möglich ist. Dieser Zeitpunkt kann insbesondere nach Abschluss der Montage der Überlastschutzvorrichtung und/oder des elektrischen Bauelements sein.

Gemäß einer bevorzugten Ausgestaltung der Erfindung ist vorgesehen, dass die Aktorvorrichtung eine durch manuelle Veränderung der äußeren Form der Aktorvorrichtung oder der Anordnung der Aktorvorrichtung relativ zum Schaltelement umschaltbare Aktorvorrichtung ist. Das Umschalten ist somit ein manuelles Umschalten durch Veränderung der äußeren Form der Aktorvorrichtung oder durch Veränderung der Anordnung der Aktorvorrichtung relativ zum Schaltelement. Die Aktivierung kann unmittelbar an der Überlastschutzvorrichtung vorgenommen werden. Der Zeitpunkt der Aktivierung kann von einem Nutzer frei gewählt werden.

Gemäß einer vorteilhaften Ausgestaltung der Erfindung ist vorgesehen, dass die Aktorvorrichtung mindestens ein Federelement aufweist, insbesondere ein Federelement ist. Durch Vorspannen des Federelements wird die Aktorvorrichtung umgeschaltet.

Insbesondere ist dabei vorgesehen, dass das Federelement eine Schnappscheibe ist oder eine Schnappscheibe aufweist. Schnappscheiben sind Federelemente, die nach dem Knackfrosch-Prinzip arbeiten. Ein Knackfrosch ist ein Federelement, das aus einem Streifen Federstahl besteht. Der Stahl ist so geprägt, dass er einen stabilen und einen metastabilen Zustand aufweist. Durch Krafteinwirkung im stabilen Zustand wird er verbogen, bis er plötzlich durch Beulen in den metastabilen Zustand springt. Zumeist weist das Federelement des Knackfroschs einen Kuppel- oder Kuppelabschnittsartigen Bereich aus, der durch das Prägen erzeugt wird. Die beiden Zustände werden in dieser Ausgestaltung der Erfindung bevorzugt dazu genutzt, einen entspannten und einen vorgespannten Zustand des Federelements zu erzeugen. Das Umschalten ist dabei ein Umschalten vom ungespannten in den vorgespannten Zustand.

Alternativ oder zusätzlich ist mit Vorteil vorgesehen, dass die Aktorvorrichtung ein intumeszentes Material und/oder ein Formgedächtnismaterial und/oder ein seine Form chemisch veränderndes Material als aktives Material aufweist.

Insbesondere ist vorgesehen, dass die Aktorvorrichtung im umgeschalteten Zustand eine mittels einer Verrastung am Schaltelement mechanisch vorgespannte Aktorvorrichtung ist. Teile der Aktorvorrichtung und/oder des Schaltelements sind bei umgeschalteter Aktorvorrichtung somit miteinander verrastet oder stehen in einem sonstigen Wirkeingriff miteinander um die Aktorvorrichtung vorzuspannen.

Alternativ oder zusätzlich ist mit Vorteil vorgesehen, dass die Aktorvorrichtung eine mittels gegenseitiger Verlagerung von Teilen oder Bereichen der Aktorvorrichtung umschaltbare (und somit aktivierbare) Einrichtung ist. Weist die Aktorvorrichtung ein nach dem Knackfrosch-Prinzip arbeitendes Federelement (zum Beispiel eine Schnappscheibe) auf, so ist die Verlagerung ein Einbeulen eines Bereichs dieses Federelements.

Gemäß einer Weiterbildung der Erfindung ist vorgesehen, dass das Schaltelement und die Aktorvorrichtung einstückig ausgebildet sind oder zumindest ein einstückig ausgebildetes gemeinsames Teil aufweisen. Dies reduziert die Anzahl der benötigten Teile und gibt eine eindeutige Verbindung zwischen Schaltelement und Aktorvorrichtung vor.

Gemäß einer bevorzugten Ausführungsform der Erfindung ist vorgesehen, dass die Überlastschutzvorrichtung eine von dem Bauelement separierbare Überlastschutzvorrichtung ist. Bauelement und Überlastschutzvorrichtung können somit - zumindest prinzipiell- unabhängig von einander manipuliert werden. Dieser Freiheitsgrad vereinfacht insbesondere die Montage von Bauelement und/oder Überlastschutzvorrichtung.

Die Erfindung betrifft weiterhin eine Anordnung mit einem Leiterbahnenträger, mindestens einem darauf angeordneten Bauelement und mindestens einer vorstehend genannten Überlastschutzvorrichtung, wobei das Basiselement mittels der Standard-Lötverbindung mit einer Leiterbahn des Leiterbahnenträgers verlötet ist, die ihrerseits mit einem Anschluss des Bauelements unmittelbar verbunden ist. Das Bauelement ist bevorzugt ein Überspannungsschutzableiter, insbesondere auf Halbleiterbasis (Suppressordiode, Varistor, etc.) oder ein gasgefüllter Überspannungsäbleiter oder ein Widerstand.

Insbesondere ist das Bauelement ein oberflächenmontiertes Bauelement (SMD-Bauelement), das bevorzugt mittels Wiederaufschmelz-Lötprozess (Reflow-Lötprozess) auf den Leiterbahnen des Leiterbahnträgers montiert ist.

Gemäß einer bevorzugten Ausführungsform der Erfindung ist vorgesehen, dass sich das Schaltelement und/oder die Aktorvorrichtung der Überlastschutzvorrichtung über das Separierelement (also mittelbar) an einer mit einem Anschluss des Bauelements unmittelbar verbundenen Leiterbahn des Leiterbahnenträgers abstützt. Alternativ oder zusätzlich ist insbesondere vorgesehen, dass sich das Schaltelement und/oder die Aktorvorrichtung der Überlastschutzvorrichtung unmittelbar an mindestens einer einen Leiterbahn abstützen.

Die Erfindung betrifft weiterhin ein Verfahren zur Herstellung eines Verbunds aus einem Schaltelement, einem Basiselement zum Verlöten des Verbunds und einem zwischen dem Schaltelement und dem Basiselement angeordneten und diese verbindenden Separierelement. Das Verfahren weist die folgenden Schritte auf: (i) Bereitstellen des Schaltelements mit einer Verlängerung des einen Endbereichs, (ii) Abkanten der Verlängerung neben den Endbereich, (iii) Einbringen eines Schmelzelements zwischen Endbereich und Verlängerung und (iv) Entfernen der beim Abkanten entstandenen Kante, wobei der verbleibende Teil der Verlängerung das Basiselement bildet. Schaltelement und Basiselement sind aus dem selben Teil, vorzugsweise einem Stanzbiegeteil, erstellt.

Gemäß einer bevorzugten Ausführungsform der Erfindung ist vorgesehen, dass die Verlängerung beziehungsweise das Basiselement wannenförmig ausgebildet wird. Die Wannenförmige Ausbildung verhindert ein Wegfließen des Schmelzelements, das vorzugsweise ein Funktionslot ist.

Nachfolgend wird die Erfindung unter Bezugnahme auf die anliegende Zeichnung anhand bevorzugter- Ausführungsformen näher erläutert.

Es zeigen
Fig. 1 ein elektronisches Bauelement und eine thermische Überlastschutzvorrichtung im nicht-aktivierten Betriebszustand gemäß einer ersten Ausführungsform der Erfindung,
Fig. 2 ein Auslöseverbund der Überlastschutzvorrichtung gebildet aus einem Schaltelement, einem Basiselement und einem zwischen dem Schaltelement und dem Basiselement angeordneten und diese verbindenden Separierelement,
Fig. 3 das Bauelement und die thermische Überlastschutzvorrichtung der Figur 1 im aktivierten Betriebszustand,
Fig. 4 das Bauelement und die thermische Überlastschutzvorrichtung der Figuren 1 und 3 im ausgelösten Betriebszustand,
Fig. 5 ein elektronisches Bauelement und eine thermische Überlastschutzvorrichtung im nicht-aktiven Betriebszustand gemäß einer zweiten Ausführungsform der Erfindung,
Fig. 6 das Bauelement und die thermische Überlastschutzvorrichtung der Figur 5 im aktivierten Betriebszustand,
Fig. 7 das Bauelement und die thermische Überlästschutzvorrichtung der Figuren 5 und 6 im ausgelösten Betriebszustand,
Fig. 8 die Ausgangssituation bei der Herstellung des Verbundes der Figur 2,
Fig. 9 ein erstes Zwischenergebnis bei der Herstellung des Verbundes der Figur 2,
Fig. 10 ein erstes Zwischenergebnis bei der Herstellung des Verbundes der Figur 2 und
Fig. 11 das Endergebnis bei der Herstellung des Verbundes der Figur 2.

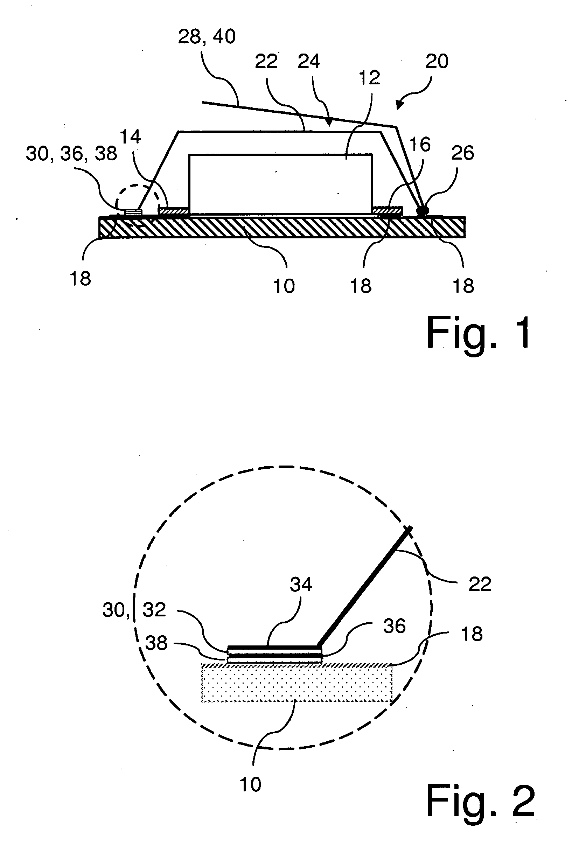

Die Figur 1 zeigt in schematischer Darstellung ein auf einem Leiterbahnenträger 10 angeordnetes elektrisches Bauelement 12. Das elektrische Bauelement 12 ist insbesondere als elektronisches Bauelement ausgebildet, das mit seinen elektrischen Anschlüssen 14, 16 auf den Leiterbahnen 18 des Leiterbahnenträgers 10 mittels Standard-Lotverbindungen (hier nicht gezeigt) verlötet ist. Weiterhin ist eine dem Bauelement 12 zugeordnete Überlastschutzvorrichtung 20 gezeigt.

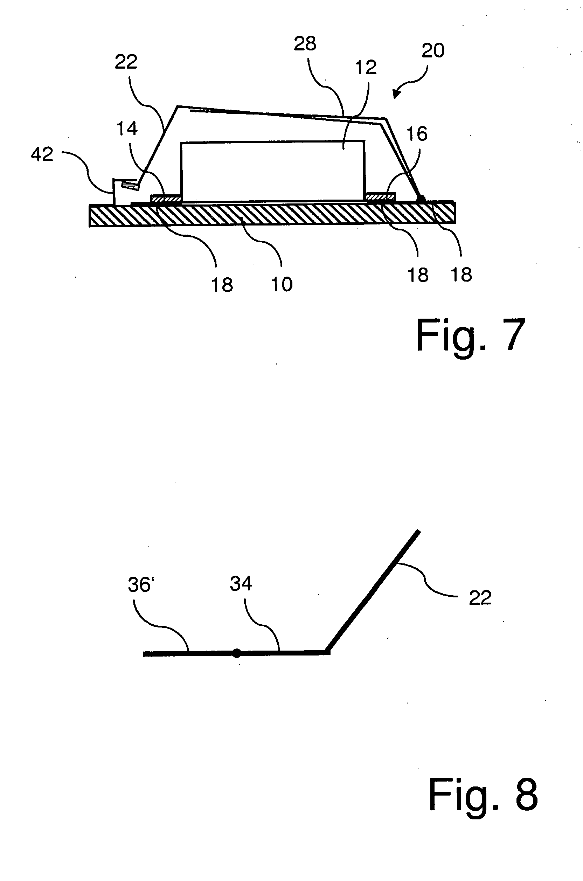

Die Überlastschutzvorrichtung 20 umfasst ein Schaltelement 22 zum Auftrennen einer elektrisch leitenden Verbindung 24 zwischen einem Stromführungselement 16 der Überlastschutzvorrichtung 20 und einem der Anschlüsse 14 des elektrischen Bauelements 20. Das Stromführungselement 26 ist ebenfalls mittels einer Standard-Lotverbindung mit einer der Leiterbahnen 18 verlötet (nicht gezeigt). Die Überlastschutzvorrichtung 20 umfasst weiterhin eine Aktorvorrichtung 28 und ein die Aktorvorrichtung 28 thermosensitiv auslösendes und als Separierelement 30 ausgebildetes Auslöseelement. Dieses Separierelement 30 ist in dem Beispiel der Figuren als Schmelzelement 32 zwischen einem Endbereich des Schaltelements 22 und einem Basiselement 36 ausgebildet, was in Fig. 2 explizit gezeigt ist. Der Herstellungsprozess des Verbundes aus Endbereich 34 des Schaltelements, dem Schmelzelement 32 und dem aus einer Verlängerung 36' des Endbereichs 34 erstellten Basiselements 36 ist in den Figuren 8 bis 11 gezeigt.

Die Fig. 2 zeigt im Detail den mittels des gestrichelten Kreises markierten Teil der Überlastschutzvorrichtung 20. Das Basiselement 36 ist in dieser Ausführungsform als Blech beziehungsweise Stanzbiegeteil ausgebildet, das auf seiner Oberseite das Schmelzelement 32 trägt und auf seiner dem Schmelzelement 32 abgewandten (Unter-)Seite mittels einer Standard-Lotverbindung 38 auf einer der Leiterbahnen 18 verlötet ist. Das gezeigte Schmelzelement 32 ist eine Lotverbindung deren Lot bei deutlich geringerer Temperatur (zum Beispiel 20°C weniger) schmilzt als das hier verwendete Standard-Lot zum Verlöten des Bauelements 12 und der Überlastschutzvorrichtung 20 auf dem Leiterbahnenträger 10. Da die Standard-Lotverbindung 38, das Basiselement 36 und das als Lotverbindung ausgebildete Separierelement 30 elektrisch leitend sind, ist die unmittelbar an dem einen Anschluss 14 angeschlossene Leiterbahn 18 im unausgelösten Zustand des Separierelements 30 elektrisch leitend mit dem Schaltelement 22 und über das Stromführungselement 26 mit der weiteren Leiterbahn 18 verbunden. Es ergibt sich also die leitende Verbindung 24. Durch das vom Separierelement 30 ausgelöste Verlagern/Verformen des Schaltelements 22 durch die Aktorvorrichtung 28 wird es ermöglicht, die leitende Verbindung 24 zu lösen und das Bauelement 12 stromfrei zu schalten.

Die Fig. 1 zeigt nun die Überlastschutzvorrichtung 20 mit Schaltelement 22 und Aktorvorrichtung 28 in einem inaktiven Zustand, bei dem das Schaltelement 22 von der als Federelement ausgebildeten Aktorvorrichtung 28 auch durch ein Auslösen mittels des Separierelements 30 nicht verlagerbar ist beziehungsweise verlagert wird, da die Aktorvorrichtung 28 in diesem Zustand keine Kraft auf das Schaltelement 22 ausübt.

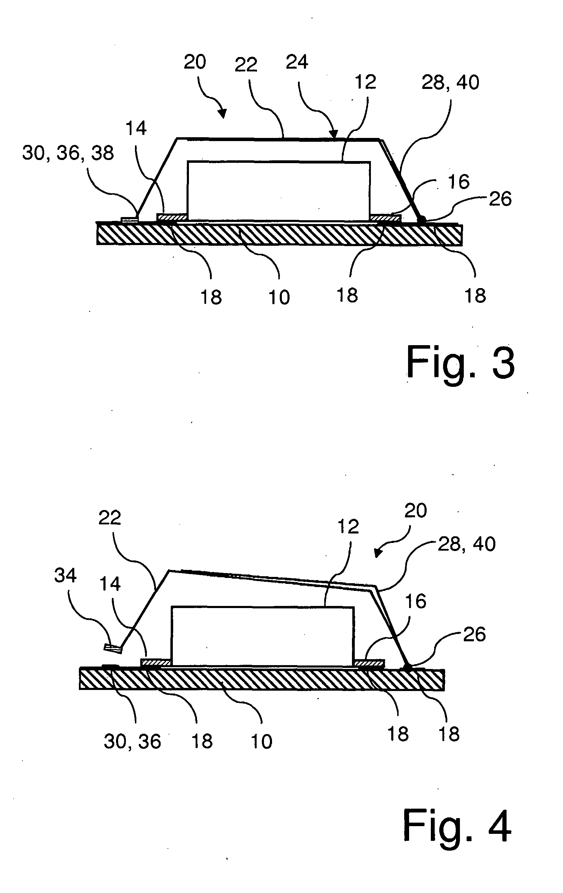

Die Fig. 3 zeigt die Überlastschutzvorrichtung 20 mit dem Schaltelement 22 und der Aktorvorrichtung 28 nach einem Umschalten in den auslösbaren Zustand, bei dem das Schaltelement 22 von der mittels des Separierelements 30 auslösbaren Aktorvorrichtung 28 verlagerbar ist. Mittels einer manuell aufzubringenden Kraft wird die als Federelement 40 ausgebildete Aktorvorrichtung 28 gegenüber dem Schaltelement 22 so verbogen/verschwenkt, dass die Aktorvorrichtung 28 mittels einer Verrastung (nicht gezeigt) am Schaltelement 22 mechanisch vorgespannt und somit in den auslösbaren Zustand umgeschaltet ist.

Die Fig. 4 deutet die aufgetrennte Verbindung von Basiselement 36 und Schaltelement 22 an. Nach dem Umschalten in den auslösbaren Zustand (Fig. 3), bei dem das Schaltelement 22 von der mittels des Separierelements 30 auslösbaren Aktorvorrichtung 28 verlagerbar ist und einem anschließenden Auslösen durch das Separierelement 30, zieht das vorgespannte Federelement 40 der Aktorvorrichtung 28 den einen Endbereich 34 von dem Basiselement 36 weg (Trennposition), sodass die elektrisch leitende Verbindung 24 getrennt wird.

Es ergeben sich folgende Vorteile: Im Montagezustand der Überlastschutzvorrichtung 20 ist diese kraftfrei. Die Montage auf dem Träger 10 kann durch einfache Bestückung, insbesondere mittels eines Bestückungsautomaten, erfolgen. Für den Lötprozess ist keine Fixierung und kein Niederhalten erforderlich. Im Anschluss an die Montage / den Lötprozess kann die Vorrichtung durch gegenseitige Verrastung (bzw. Durchbeulen) von Schaltelement 22 und Federelement 40 aktiviert werden. Da das Basiselement 36 mit Standard-Lot auf der Leiterbahn 18 verlötbar ist, kann die Überlastschutzvorrichtung 20 mit den Bauteilen 12 zusammen von einer Maschine verlötet werden.

Im Betriebszustand ist der von Federelement 40 und Kontaktierungsstelle mit Basiselement 36 und Schmelzelement 32 auf dem Träger 10 gebildete Schalter geschlossen. Eine unzulässige Erwärmung des Bauelements 12 über die Aktivierungstemperatur führt zu einer Aktivierung der sich im auslösbaren Zustand befindlichen Vorrichtung 20. Beim Überschreiten der Aktivierungstemperatur (Lotschmelztemperatur des als Lot ausgebildeten Schmelzelements, nicht der höheren Schmelztemperatur des Standard-Lots) führt die Federspannung des Federelements 40 zum Öffnen des so gebildeten Schalters und das Bauelement 12 ist damit in einen sicheren Zustand überführt.

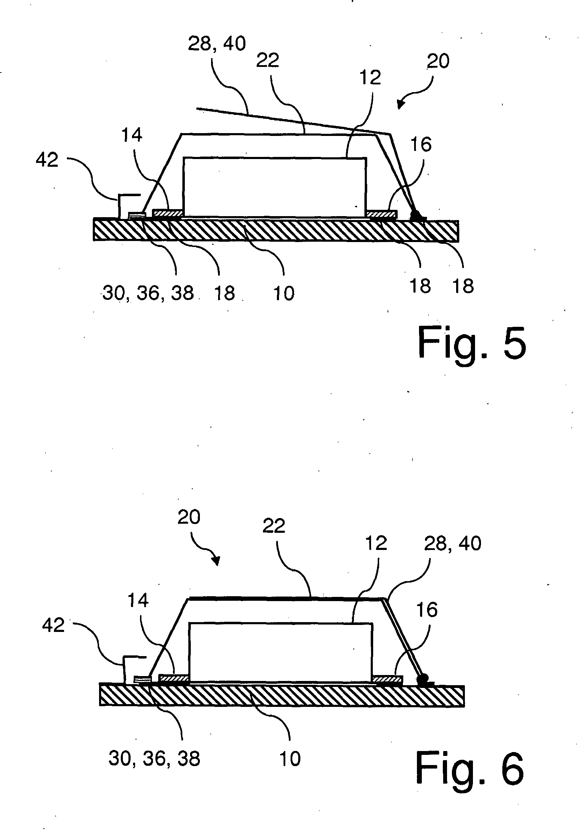

Die Figuren 5 bis 7 zeigen eine Anordnung, bei der die Überlastschutzvorrichtung 20 die Anschlüsse 14, 16 mittels des als Kurzschlussbügel ausgebildeten Schaltelements 22 bei thermischer Überlast kurzschließt. Das elektrisch leitfähige Schaltelement 22 wird zu dem Bauelement 12 angeordnet. Das Schaltelement 22 wird dazu ebenfalls auf dem Träger 10 befestigt. Zusammen mit einem auf dem Träger 10 befestigten und als Kurzschlussmetall ausgebildeten anderen Stromführungselement 42 bildet der Endbereich 34 des Schaltelements 22 einen elektrischen Schalter.

Dabei zeigt Fig. 5 die Überlastschutzvorrichtung 20 mit dem Schaltelement 22 und der Aktorvorrichtung 28 in einem inaktiven Zustand, bei dem das Schaltelement 22 von der Aktorvorrichtung 28 auch durch ein Auslösen mittels des Separierelements 30 nicht verlagerbar ist beziehungsweise verlagert wird, da die Aktorvorrichtung 28 in diesem Zustand keine Kraft auf das Schaltelement 22 ausübt. Das Separierelement 30 ist auch hier als Schmelzelement 32 ausgebildet, zum Beispiel als Schmelzkunststoff.

Die Fig. 6 zeigt die Überlastschutzvorrichtung 20 mit dem Schaltelement 22 und der Aktorvorrichtung 28 nach einem Umschalten in den auslösbaren Zustand, bei dem das Schaltelement 22 von der mittels des Separierelements 30 auslösbaren Aktorvorrichtung 28 verlagerbar ist. Mittels der manuell aufzubringenden Kraft wird die Aktorvorrichtung 28 gegenüber dem Schaltelement 22 so verbogen/verschwenkt, dass die Aktorvorrichtung 28 mittels einer Verrastung (nicht gezeigt) am Schaltelement 22 mechanisch vorgespannt und somit in den auslösbaren Zustand umgeschaltet ist. Die Aktorvorrichtung 28 ist in dieser Ausführungsform als Federelement 40 ausgebildet.

Die Fig. 7 zeigt das mittels des als Kurzschlussbügel ausgebildeten Schaltelements 22 kurzgeschlossene Bauelement 12 nach dem Auslösen durch das Separierelement 30. Das vorgespannte Federelement 40 der Aktorvorrichtung 28 zieht den einen Endbereich 34 vom Basiselement 36 weg und hebt es soweit an, dass über das hakenförmig ausgebildete andere Stromführungselement 42 und entsprechende Leiterbahnen 18 der Kurzschluss entsteht (Kurzschlussposition).

Es ergeben sich folgende Vorteile: Im Montagezustand der Überlastschutzvorrichtung 20 ist diese kraftfrei. Die Montage auf dem Träger 10 kann durch einfache Bestückung, insbesondere mittels eines Bestückungsautomaten, erfolgen. Für den Lötprozess ist keine Fixierung und kein Niederhalten erforderlich. Im Anschluss an die Montage / den Lötprozess kann die Vorrichtung durch gegenseitige Verrastung (bzw. Durchbeulen) von Schaltelement 22 und Federelement 40 aktiviert werden. Da das Basiselement 36 mit Standard-Lot auf der Leiterbahn 18 verlötbar ist, kann die Überlastschutzvorrichtung 20 mit den Bauteilen 12 zusammen von einer Maschine verlötet werden.

Im Betriebszustand ist der von Federelement 40 und Kontaktierungsstelle mit Basiselement 36 und Schmelzelement 32 auf dem Träger 10 gebildete Schalter geöffnet. Eine unzulässige Erwärmung des Bauelements 12 über die Aktivierungstemperatur hinaus führt zu einer Aktivierung der sich im auslösbaren Zustand befindlichen Überlastschutzvorrichtung 20. Beim Überschreiten der Aktivierungstemperatur (Lotschmelztemperatur des als Lot ausgebildeten Schmelzelements) führt die Federspannung des Federelements 40 zum Schließen des so gebildeten Schalters und das Bauelement 12 ist damit in einen sicheren Zustand überführt.

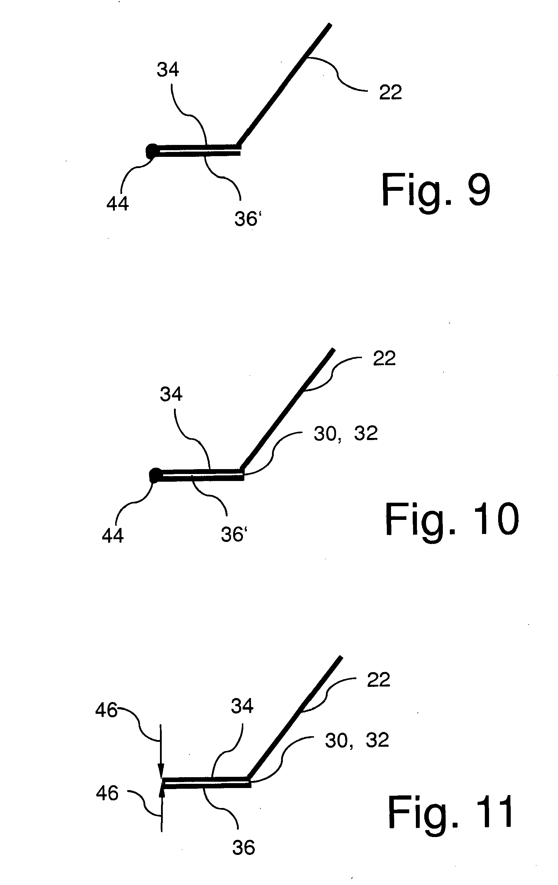

Die Figuren 8 bis 11 skizzieren ein Verfahren zur Herstellung eines Verbunds aus dem Schaltelement 22, dem Basiselement 36 und dem zwischen dem Schaltelement 22 und dem Basiselement 36 angeordneten und diese verbindenden Separierelement 30. Dieser Verbund ist bereits in Fig. 2 gezeigt. Das Herstellungsverfahren weist folgende Schritte auf:
- Bereitstellen des Schaltelements 22 mit einer Verlängerung 36' des einen Endbereichs 34 (Fig. 8),
- Abkanten der Verlängerung 36' neben beziehungsweise unter den Endbereich 34 (Fig. 9),
- Einbringen des als Funktionslot ausgebildeten Schmelzelements 32 zwischen Endbereich 34 und Verlängerung 36' (Fig. 10) und
- Entfernen der beim Abkanten entstandenen Kante 44 (angedeutet durch die Pfeile 46), wobei der nun nicht mehr formschlüssig mit dem Endbereich 34 verbundene verbleibende Teil der Verlängerung 36' das Basiselement 36 bildet (Fig. 11).

Das Entfernen der Kante 44 kann zum Beispiel mittels eines Schneid- oder eines anderen Trennprozesses (angedeutet durch die Pfeile 46) erfolgen. Als Resultat ergibt sich der in Fig. 2 gezeigte Verbund. Dieser ist Teil der Überlastschutzvorrichtung 20.

Optional wird die Verlängerung 36' beziehungsweise das Basiselement 36 wannenförmig ausgebildet. Die wannenförmige Ausbildung des Basiselements 36 verhindert ein Wegfließen des Schmelzelements 32 (Funktionslots) beim späteren Verlöten des Verbunds beziehungsweise der Überlastschutzvorrichtung 20 mittel Standard-Lot an der Unterseite des Basiselements 36.

**Bezugszeichenliste**

| | |
|---|---|
| Leiterbahnenträger | 10 |
| Bauelement | 12 |
| Anschluss | 14 |
| Anschluss | 16 |
| Leiterbahn | 18 |
| Überlastschutzvorrichtung | 20 |
| Schaltelement | 22 |
| leitende Verbindung | 24 |
| Stromführungselement | 26 |
| Aktorvorrichtung | 28 |
| Separierelement | 30 |
| Schmelzelement | 32 |
| Endbereich | 34 |
| Basiselement | 36 |
| Verlängerung | 36' |
| Standard-Lotverbindung | 38 |
| Federelement | 40 |
| Anderes Stromführungselement | 42 |
| Kante | 44 |
| Pfeile | 46 |

## Patentansprüche

1. Thermische Überlastschutzvorrichtung (20) zum Schutz eines elektrischen Bauelements (12), insbesondere elektronischen Bauelements, die ein Schaltelement (22) zum Kurzschließen von Anschlüssen (14, 16) des Bauelements (12) oder zum Auftrennen einer elektrisch leitenden Verbindung (24) zwischen mindestens einem der Anschlüsse (14) und einem Stromführungselement (26) der Überlastschutzvorrichtung (20), eine Aktorvorrichtung (28) zum Verlagern des Schaltelements (22) in eine entsprechende Kurzschlussposition oder Trennposition, ein die Aktorvorrichtung (28) thermosensitiv auslösendes und als Separierelement (30) ausgebildetes Auslöseelement und ein Basiselement (36) aufweist, mit dem das Separierelement (30) verbunden ist, wobei das Basiselement (36) an einer dem Separierelement (30) abgewandten Seite des Basiselements (36) mittels einer Standard-Lotverbindung (38) verlötbar ist,
**dadurch gekennzeichnet, dass** die Aktorvorrichtung (28) im auslösbaren Zustand eine mittels einer Verrastung am Schaltelement (22) mechanisch vorgespannte Aktorvorrichtung (28) ist.

2. Überlastschutzvorrichtung nach Anspruch 1, wobei das Separierelement (30) als ein durch Schmelzen auslösendes Schmelzelement (32) ausgebildet ist.

3. Überlastschutzvorrichtung nach Anspruch 1 oder 2, wobei das durch Schmelzen auslösendes Schmelzelement (32) einen niedrigeren Schmelzpunkt aufweist als das Lot der Standard-Lotverbindung (38).

4. Überlastschutzvorrichtung nach einem der vorhergehenden Ansprüche, wobei das Basiselement (36) über das unausgelöste Separierelement (30) mit dem Schaltelement (22) mechanisch verbunden ist.

5. Überlastschutzvorrichtung nach Anspruch 4, wobei das Basiselement (36) elektrisch leitfähig ausgebildet ist und über das unausgelöste Separierelement (30) mit dem Schaltelement (22) auch elektrisch leitend verbunden ist.

6. Überlastschutzvorrichtung nach einem der vorhergehenden Ansprüche, wobei die Aktorvorrichtung (28) zu ihrer Aktivierung von einem inaktiven Zustand, bei dem das Schaltelement (22) von der Aktorvorrichtung (28) auch durch Auslösen mittels Separierelement (30) nicht verlagerbar ist, in einen auslösbaren Zustand umschaltbar ist, bei dem das Schaltelement (22) von der Aktorvorrichtung (28) verlagerbar ist.

7. Überlastschutzvorrichtung nach einem der vorhergehenden Ansprüche, wobei die Aktorvorrichtung (28) mindestens ein Federelement (40) aufweist, insbesondere ein Federelement (40) ist.

8. Überlastschutzvorrichtung nach Anspruch 7, wobei das Federelement (40) eine Schnappscheibe ist.

9. Überlastschutzvorrichtung nach einem der vorhergehenden Ansprüche, wobei diese von dem Bauelement (12) separierbar ist.

10. Anordnung mit einem Leiterbahnenträger (10), mindestens einem darauf angeordneten Bauelement (12) und mindestens einer Überlastschutzvorrichtung (20) nach einem der Ansprüche 1 bis 9, wobei das Basiselement (36) mittels einer Standard-Lotverbindung (38) mit einer Leiterbahn (18) des Leiterbahnenträgers (10) verlötet ist, die mit einem Anschluss (14) des Bauelements (12) unmittelbar verbunden ist.

11. Anordnung nach Anspruch 10, wobei sich das Schaltelement (22) und/oder die Aktorvorrichtung (28) der Überlastschutzvorrichtung (20) unmittelbar an mindestens einer einen Leiterbahn (18) abstützen.

12. Verfahren zur Herstellung einer thermischen Überlastschutzvorrichtung (20) nach einem der Ansprüche 1 bis 9, mit einem Auslöse-Verbund wobei der Verbund aus einem Schaltelement (22), einem Basiselement (36) zum Verlöten des Verbunds und einem zwischen dem Schaltelement (22) und dem Basiselement (36) angeordneten und diese verbindenden und als Schmelzelement (32) ausgebildeten Separierelement (30) besteht, **gekennzeichnet durch** die folgenden Schritte:
- Bereitstellen des Schaltelements (22) mit einer Verlängerung (36') des einen Endbereichs (34),
- Abkanten der Verlängerung (36') neben den Endbereich (34),
- Einbringen des Schmelzelements (32) zwischen Endbereich (34) und Verlängerung (36') und
- Entfernen der beim Abkanten entstandenen Kante (44), wobei der verbleibende Teil der Verlängerung (36') das Basiselement (36) bildet.

13. Verfahren nach Anspruch 12, wobei die Verlängerung (36') beziehungsweise das Basiselement (36) wannenförmig ausgebildet wird.

## Claims

1. A thermal overload protection device (20) for protecting an electrical component (12), in particular an electronic component, said device having a switching element (22) for short-circuiting connections (14, 16) of the component (12) or for disconnecting an electrically conductive connection (24) between at least one of the connections (14) and a current-carrying element (26) of the overload protection device (20), an actuator device (28) for displacing the switching element (22) into a corresponding short-circuit position or disconnection position, a tripping element that thermosensitively trips the actuator device (28) and is formed as a separating element (30), and a base element (36), to which the separating element (30) is connected, wherein the base element (36) can be soldered by means of a standard soldered joint (38) on a side of the base element (36) facing away from the separating element (30), **characterised in that** the actuator device (28) in the trippable state is an actuator device (28) mechanically prestressed at the switching element (22) by means of a latching mechanism.

2. The overload protection device according to Claim 1, wherein the separating element (30) is formed as a fusible element (32) having a tripping effect by melting.

3. The overload protection device according to Claim 1 or 2, wherein the fusible element (32) having a tripping effect by melting has a lower melting point than the solder of the standard soldered joint (38).

4. The overload protection device according to one of the preceding claims, wherein the base element (36) is mechanically connected to the switching element (22) via the untripped separating element (30).

5. The overload protection device according to Claim 4, wherein the base element (36) is electrically conductive and is also electrically conductively connected to the switching element (22) via the untripped separating element (30).

6. The overload protection device according to one of the preceding claims, wherein the actuator device (28) for activation thereof can be switched over from an inactive state in which the switching element (22) cannot be displaced by the actuator device (28), not even by tripping by means of the separating element (30), into a trippable state in which the switching element (22) can be displaced by the actuator device (28).

7. The overload protection device according to one of the preceding claims, wherein the actuator device (28) has at least one spring element (40), in particular is a spring element (40).

8. The overload protection device according to Claim 7, wherein the spring element (40) is a snap dome.

9. The overload protection device according to one of the preceding claims, wherein this can be separated from the component (12).

10. An arrangement comprising a conductor track carrier (10), at least one component (12) arranged thereon, and at least one overload protection device (20) according to one of Claims 1 to 9, wherein the base element (36) is soldered by means of a standard soldered joint (38) to a conductor track (18) of the conductor track carrier (10), which conductor track is directly connected to a connection (14) of the component (12).

11. The arrangement according to Claim 10, wherein the switching element (22) and/or the actuator device (28) of the overload protection device (20) are/is directly supported on at least one conductor track (18).

12. A method for producing a thermal overload protection device (20) according to one of Claims 1 to 9, comprising a tripping composite, wherein the composite consists of a switching element (22), a base element (36) for soldering the composite, and a separating element (30), which is arranged between the switching element (22) and the base element (36) and connects them, and which is formed as a fusible element (32), **characterised by** the following steps:
- providing the switching element (22) with an extension (36') of one end region (34),
- folding the extension (36') next to the end region (34),
- introducing the fusible element (32) between the end region (34) and the extension (36'), and
- removing the edge (44) created during folding, wherein the remaining part of the extension (36') forms the base element (36).

13. The method according to Claim 12, wherein the extension (36') or the base element (36) is trough-shaped.

## Revendications

1. Dispositif de protection contre les surcharges thermiques (20), destiné à la protection d'un composant électrique (12), notamment d'un composant électronique, qui comprend un élément de commutation (22) pour la mise en court-circuit de bornes (14, 16) du composant (12) ou pour l'interruption d'une liaison électriquement conductrice (24) entre au moins l'une des bornes (14) et un élément conducteur de courant (26) du dispositif de protection contre les surcharges (20), un dispositif actionneur (28) pour le déplacement de l'élément de commutation (22) vers une position de court-circuit ou d'interruption correspondante, un élément de déclenchement assurant le déclenchement de manière thermosensible du dispositif actionneur (28) et conçu sous la forme d'un élément de séparation (30), et un élément de base (36), avec lequel l'élément de séparation (30) est relié, où l'élément de base (36) peut être soudé sur une face de l'élément de base (36) opposée à l'élément de séparation (30) au moyen d'une liaison par brasage standard (38),
**caractérisé en ce que** le dispositif actionneur (28), dans un état déclenché, est un dispositif actionneur (28) mécaniquement précontraint sur l'élément de commutation (22) au moyen d'un encliquetage.

2. Dispositif de protection contre les surcharges selon la revendication 1, dans laquelle l'élément de séparation (30) est conçu sous la forme d'un élément fusible (32) se dissolvant.

3. Dispositif de protection contre les surcharges selon les revendications 1 ou 2, dans lequel l'élément fusible (32) se dissolvant par fusion présente un point de fusion inférieur à celui du produit de brasage de la liaison par brasage standard (38).

4. Dispositif de protection contre les surcharges selon l'une des revendications précédentes, dans lequel l'élément de base (36) est relié mécaniquement avec l'élément de commutation (22) par l'intermédiaire de l'élément de séparation (30) non dissout.

5. Dispositif de protection contre les surcharges selon la revendication 4, dans lequel l'élément de base (36) est conçu électriquement conducteur et est relié de manière électriquement conductrice avec l'élément de commutation (22) par l'intermédiaire de l'élément de séparation (30) non dissout.

6. Dispositif de protection contre les surcharges selon l'une des revendications précédentes, où le dispositif actionneur (28) peut être commuté vers un état de dissolution pour son activation à partir d'un état inactif, dans lequel l'élément de commutation (22) ne peut pas être déplacé du dispositif actionneur (28) vers un état de dissolution, même au moyen de l'élément de séparation (30), dans lequel l'élément de commutation (22) peut être déplacé du dispositif actionneur (28).

7. Dispositif de protection contre les surcharges selon l'une des revendications précédentes, dans lequel le dispositif actionneur (28) présente au moins un élément élastique (40), notamment un élément ressort (40).

8. Dispositif de protection contre les surcharges selon la revendication 7, dans lequel l'élément élastique (40) est un disque cloquant.

9. Dispositif de protection contre les surcharges selon l'une des revendications précédentes, dans lequel celui-ci peut être séparé du composant (12).

10. Ensemble avec un support de conducteur (10, au moins un composant (12) qui est disposé dessus et au moins un dispositif de protection contre les surcharges (20) selon l'une des revendications 1 à 9, dans lequel l'élément de base (36) est brasé avec la bande de conducteur (18) du support de conducteur (10) au moyen d'une liaison par brasage standard (38), qui est immédiatement reliée avec une borne (14) du composant (12).

11. Ensemble selon la revendication 10, dans lequel l'élément de commutation (22) et/ou le dispositif actionneur (28) du dispositif de protection contre les surcharges (20) s'appuient immédiatement sur au moins l'une des bandes de conducteur (18).

12. Procédé de fabrication d'un dispositif de protection contre les surcharges (20) selon l'une des revendications 1 à 9, avec un composite de dissolution, dans lequel le composite est constitué d'un élément de commutation (22), d'un élément de base (36), pour le brasage du composite, et d'un élément de séparation (30) conçu sous la forme d'un élément fusible (32), disposé entre l'élément de commutation (22) et l'élément de base (36) et reliant ceux-ci, **caractérisé par** les étapes suivantes :
- mise au point de l'élément de commutation (22) avec une extension (36') de l'une des parties terminales (34),
- ébavurage de l'extension (36') à côté de la partie terminale (14),
- apport de l'élément fusible (32) entre la partie terminale (34) et l'extension (36'), et
- enlèvement du bord (44) provenant de l'ébavurage, où la partie résiduelle de l'extension (36') constitue l'élément de base (36).

13. Procédé selon la revendication 12, dans lequel l'extension (36'), respectivement, l'élément de base (36), est conçu sous la forme d'une cuve.
